# EUROPEAN PATENT APPLICATION

(11) **EP 1 930 469 A1**
(43) Date of publication of application: **11.06.2008**
(21) Application number: 07116733.2
(22) Date of filing: 19.09.2007
(51) Int. Cl.: C23C 16/02, C23C 16/40, C30B 29/16, C30B 29/60

(54) **Method of forming oxide-based nano-structured material**

(30) Priority: 05.12.2006 KR 20060122630; 13.04.2007 KR 20070036582
(71) Applicant: Electronics and Telecommunications Research Institute, Daejeon-city (KR)
(72) Inventor: Kim, Sang Hyeob, Daejeon (KR); Lee, Sun Young, Seoul (KR); Maeng, Sung Lyul, Cheongju (KR); Myoung, Hey Jin, Daejeon (KR)
(74) Representative: Betten & Resch

(57) **Abstract**

Provided is a method of forming an oxide-based nano-structured material including growing a nano-structured material using a nano-nucleus having the same composition as the desired oxide-based nano-structured material. A solution is coated on a substrate, the solution including: an organic precursor containing M which is a transition metal or a semi metal; and an organic solvent in which the organic precursor is dissolved. A nano-nucleus having a composition of MxOy is formed on the substrate by annealing the substrate. A nano-structured material having a composition of MxOy is formed by growing the nano-nucleus while supplying a reaction precursor containing M into the nano-nucleus, and the nano-structured material is annealed.

## Description

### CROSS-REFERENCE TO RELATED PATENT APPLICATION

This application claims the benefit of Korean Patent Application Nos. 10-2006-0122630, filed on December 5, 2006, and 10-2007-0036582, filed on April 13, 2007, in the Korean Intellectual Property Office, the disclosures of which are incorporated herein in their entirety by reference.

### BACKGROUND OF THE INVENTION

### 1. Field of the Invention

The present invention relates to a method of forming an oxide-based nano-structured material, and more particularly, to a method of forming a nano-structured material using an oxide of a transition metal or a semi metal.

### 2. Description of the Related Art

Oxide-based nano-structured materials containing a metal or non-metal element are potentially applicable to the field of nano-electronic devices such as field effect transistors (FETs), single electron transistors (SETs), photodiodes, biochemical sensors, and logic circuits, Accordingly, research on properties of nano-structured materials and methods of forming the same have been conducted in various technical fields.

According to a conventional method of forming an oxide-based nano-structured material, a noble metal such as Au, Ag, Pd, and Pt is deposited on a substrate using sputtering or thermal evaporation to form a nano-level noble metal thin film, and then the substrate is annealed to form noble metal particles or a noble metal cluster. Then, an oxide-based nano-structured material is grown from the substrate using the noble metal particles or the noble metal cluster as a nucleus through a physical or chemical process.

However, this conventional method of forming an oxide-based nano-structured material is complicated and requires a large area substrate, and thus also requires large-scale equipment for the growth of the oxide-based nano-structured material. Further, as a result of the complicated process of forming the noble metal nano particles which function as the nucleus, and then growing the oxide-based nano-structured material therefrom, the noble metal remains in the resulting oxide-based nano-structured material as an impurity. In addition, the manufacturing costs increase due to the noble metal. Therefore, mass production of the oxide-based nano-structured material is limited.

In addition, a connection between the noble metal particles or the noble metal cluster and the oxide-based nano-structured material is incomplete since they have different compositions, and a dopant is not easily injected into the resulting nano-structure. In particular, although the material itself used in the nano-structured material has excellent electrical properties, it is not easy to control growth rate, size, and shape of the nano-structured material according to a plane index of the noble metal used as the nucleus. Thus, the oxide-based nano-structured material cannot have a uniform composition, shape and size, and as such is unable to have stable properties.. Therefore, since the oxide-based nano-structured material formed according to the conventional method provides unstable electrical properties, application to integrated high-speed electronic circuits is limited..

### SUMMARY OF THE INVENTION

The present invention provides a method of forming an oxide-based nano-structured material for realizing a oxide-based nano-structured material having a uniform composition at low costs by growing the oxide-based nano-structured material without impurities, and providing stable electrical properties appropriate for the application to be minimized and integrated electronic circuits.

According to an aspect of the present invention, there is provided a method of forming an oxide-based nano-structured material, the method including:
coating a solution on a substrate, the solution including (a) an organic precursor containing M which is a transition metal or a semi metal and (b) an organic solvent dissolving the organic precursor;
forming a nano-nucleus having a composition of MxOy in which x is an integer of 1 to 3 and y is an integer of 1 to 6 on the substrate by annealing the substrate coated with the solution;
forming a nano-structured material having a composition of MxOy in which x is an integer of 1 to 3 and y is an integer of 1 to 6 by growing the nano-nucleus while supplying a reaction precursor containing M into the nano-nucleus; and
annealing the nano-structured material.

The solution may be prepared by mixing the organic precursor and an alcohol-based organic solvent in a volume ratio of between 1:1 and 1:5000.

The coating of the solution on the substrate may be performed using dipping, spin coating, or spray coating.

The annealing of the substrate coated with the solution may be performed at a temperature in the range of 50 to 500°C for 1 second to 1 hour.

The forming a nano-structured material may be performed using a process selected from the group consisting of sputtering, thermal chemical vapor deposition, metal-organic CVD (MOCVD), vapor liquid solid epitaxial (VSLE), pulsed laser deposition (PLD), and sol-gel process to grow the nano-nucleus.

The annealing the nano-structured material may be performed at a temperature in the range of 100 to 1200°C for 1 minute to 24 hours.

The nano-structured material may have a nano-wire shape, a nano-rod shape, or a nano-wall shape.

According to a method of forming an oxide-based nano-structured material of the present invention, the nano-structured material does not include an impurity since the oxide-based nano-structured material is grown using a nano-nucleus having the same composition as the desired oxide-based nano-structured material. Further, an oxide-based nano-structured material having excellent crystalline properties can be formed through a simple process at low manufacturing costs by employing a wet chemical process to form the nano-nucleus. Therefore, the oxide-based nano-structured material formed according to the present invention can provide a uniform connection when applied to minimized and integrated electronic circuits, and also provide stable electrical and optical properties..

### BRIEF DESCRIPTION OF THE DRAWINGS

The above and other features and advantages of the present invention will become more apparent by describing in detail exemplary embodiments thereof with reference to the attached drawing in which:

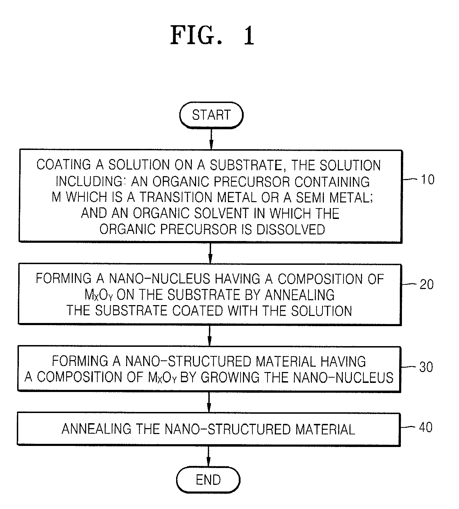

FIG. 1 is a flow chart illustrating a method of forming an oxide-based nano-structured material according to an embodiment of the present invention.

### DETAILED DESCRIPTION OF THE INVENTION

Hereinafter, the present invention will now be described more fully with reference to the accompanying drawing, in which exemplary embodiments of the invention are shown. The invention may, however, be embodied in many different forms and should not be construed as being limited to the embodiments set forth herein; rather, these embodiments are provided so that this disclosure will be thorough and complete, and will fully convey the concept of the invention to those skilled in the art.

FIG. 1 is a flow chart illustrating a method of forming an oxide-based nano-structured material according to an embodiment of the present invention.

Referring to FIG. 1, in operation 10, a solution is coated on a substrate, the solution including: an organic precursor containing M which is a transition metal or a semi metal; and an organic solvent in which the organic precursor is dissolved.

For this, an organic precursor containing M is mixed with an organic solvent to prepare the solution, The volume ratio between the organic precursor and an alcohol-based organic solvent is in the range of about 1:1 to 1,5000 in the solution,

The organic precursor may be M(CH₃COO)₂·2H₂O. Here, M may be a transition metal selected from the group consisting of Ti, V, Cr, Zn, Y, Zr and Nb, or a semi metal selected from the group consisting of Si, Ge and As.

The organic solvent may be an alcohol-based organic solvent such as methanol and ethanol.

The solution may be coated on the substrate using dipping, spin coating, or spray coating. The substrate may be formed of Al₂O₃, quartz, Si, GaN, or glass.

When the solution is coated using the dipping, for example, the following process can be performed. First, the organic precursor containing M, for example, M(CH₃COO)₂·2H₂O is dissolved in the alcohol-based organic solvent such as methanol, ethanol, and isopropyl alcohol (IPA) in a volume ratio between 1:1 and 1:5000, and the solution is stirred at room temperature for about 1 minute to 24 hours. Then, the substrate is dipped in the stirred solution for about 1 second to 1 hour to uniformly coat the substrate with the solution. Then, the substrate is taken out of the solution. The thickness of the thin film formed of the solution on the substrate may be adjusted to about 1 to 1000 nm by controlling the dipping time or other conditions

For example, when the solution is coated on the substrate using the spin coating, about 0.01 to 100 ml of the solution is dropped on the substrate using a pipette while rotating the substrate at about 100 to 10000 rpm to form a thin film on the substrate.

Also for example, when the solution is coated on the substrate using the spray coating, the solution can be thinly coated on the substrate using appropriate spray equipment.

In this embodiment, M(CH₃COO)_{2·}2H₂O is used as the organic precursor containing M and an alcohol-based organic solvent is used as the organic solvent, but the invention is not limited thereto. For example, the organic precursor may be M(CH₃COO)_{2·}H₂O, M(CH₃COO)₂, M(CH₃)₂, M(C₂H₅)₂, M(C₅H₇O₂)₂, or the like. Further, the organic solvent may be a non-alcohol-based organic solvent.

In operation 20, the substrate coated with the solution is annealed to form a nano-nucleus having a composition of MxOy in which x is an integer of 1 to 3 and y is an integer of 1 to 6 on the substrate.

The annealing to form the nano-nucleus may be performed using a hot plate, a furnace, a vacuum chamber, or the like The annealing may be performed at a temperature in the range of about 50 to 500°C for about 1 second to 1 hour. While the organic solvent in the solution coated on the substrate is volatilized through the annealing, a plurality of nano-nuclei of an oxide having a uniform size formed of a transition metal or a semi metal which are dissolved in the solution are formed. The nano-nuclei may have about several to several tens of nanometers.

For example, when Zn(CH₃COO)₂·2H₂O is used as the organic precursor, a nano-nuclei including ZnO is formed on the substrate.

In operation 30, the nano-nuclei grow to form a nano-structured material having a composition of MxOy in which x is an integer of 1 to 3 and y is an integer of 1 to 6 on the substrate to a desired size.

A physiochemical process such as sputtering, thermal chemical vapor deposition, metal-organic CVD (MOCVD), vapor liquid solid epitaxial (VSLE), pulsed laser deposition (PLD), and sol-gel process may be used to grow the nano-nuclei.

While the nano-nuclei grow, a reaction precursor including M may be supplied to the nano-nuclei as a source material for the growth of the nano-nuclei. For example, Zn(CH₃)₂ as an M source material, and O₂ gas as an O source can each be supplied to the substrate when using MOCVD for the growth of the nano-nuclei. Here, Ar can be used as a carrier gas.

The nano-structured material grown from the nano-nuclei may have various shapes such as a nano-wire shape, a nano-rod shape, and a nano-wall shape.

In operation 40, the nano-structured material is annealed.

The annealing of the nano-structured material may be performed using a hot plate, a furnace, a vacuum chamber, or the like. The annealing may be performed at a temperature in the range of about 100 to 1200°C for about 1 minute to 24 hours. The temperature at which the nano-structured material is annealed in this operation may be higher than that at which the substrate is annealed in operation 20. Further, the annealing time for the nano-structured material may be longer than that for the substrate in operation 20. However, those conditions are not necessary, and the annealing can be performed on conditions contrary to those described above to obtain the purpose of the annealing in operation 40. The annealing of the nano-structured material may be performed in normal atmospheric conditions or a vacuum chamber containing oxygen.

The oxide-based nano-structured material having a uniform composition can be obtained since lack of oxygen in the nano-structured material is compensated by annealing of the nano-structured material. Further, a lattice-matched nano-structured material can be obtained due to improvement in crystallinity of the nano-structured material, and thus the crystal quality can be improved. The nano-structured material having excellent crystallinity can be employed as a component in diodes or optoelectronic devices to improve electrical and optical properties of the devices.

According to a method of forming an oxide-based nano-structured material of the present invention, a nano-nucleus having the same composition as the desired oxide-based nano-structured material is used to grow the oxide-based nano-structured material, and the nano-nucleus is formed using a wet chemical process. Since the oxide-based nano-structured material according to the present invention is grown using a nano-nucleus having the same composition as the desired oxide-based nano-structured material, the nano-structured material does not include impurities. Thus, the process of forming the nano-structured material can be simplified, and the costs therefor can be lowered compared to conventional methods" Further, the crystal quality can be improved by realizing the nano-structured material having a uniform composition, and the injection of a doping element can be easily controlled when the resulting nano-structured material is doped. The oxide-based nano-structured material formed according to the present invention can provide a uniform connection when applied to minimized and integrated electronic circuits, and also provide stable electrical and optical properties.

The oxide-based nano-structured material formed according to the present invention can be widely applied to the fields of nano-electronic devices such as FETs, SETs, photodiodes, biochemical sensors, and logic circuits, solar batteries, or displays.

While the present invention has been particularly shown and described with reference to exemplary embodiments thereof, it will be understood by those of ordinary skill in the art that various changes in form and details may be made therein without departing from the spirit and scope of the present invention as defined by the following claims.

## Claims

1. A method of forming an oxide-based nano-structured material, the method comprising;
coating a solution on a substrate, the solution including (a) an organic precursor containing M which is a transition metal or a semi metal and (b) an organic solvent dissolving the organic precursor;
forming a nano-nucleus having a composition of MxOy in which x is an integer of 1 to 3 and y is an integer of 1 to 6 on the substrate by annealing the substrate coated with the solution;
forming a nano-structured material having a composition of MxOy in which x is an integer of 1 to 3 and y is an integer of 1 to 6 by growing the nano-nucleus while supplying a reaction precursor containing M into the nano-nucleus; and
annealing the nano-structured material.

2. The method of claim 1, wherein M is a transition metal selected from the group consisting of Ti, V, Cr, Zn, Y, Zr and Nb.

3. The method of claim 1, wherein M is a semi metal selected from the group consisting of Si, Ge and As.

4. The method of one of claims 1 to 3, wherein the solution is prepared by mixing M(CH₃COO)₂·2H₂O as the organic precursor and an alcohol-based organic solvent as the organic solvent.

5. The method of claim 4, wherein the organic precursor and the alcohol-based organic solvent are mixed in a volume ratio of between 1:1 and 1:5000.

6. The method of one of claims 1 to 5, wherein the coating of the solution on the substrate is performed using dipping, spin coating, or spray coating.

7. The method of one of claims 1 to 6, wherein the annealing of the substrate coated with the solution is performed at a temperature in the range of 50 to 500°C.

8. The method of claim 7, wherein the annealing of the substrate coated with the solution is performed for a time in the range of 1 second to 1 hour.

9. The method of one of claims 1 to 8, wherein the forming of a nano-structured material is performed using a process selected from the group consisting of sputtering, thermal chemical vapor deposition, metal-organic CVD (MOCVD), vapor liquid solid epitaxial (VSLE), pulsed laser deposition (PLD), and a sol-gel process to grow the nano-nucleus.

10. The method of one of claims 1 to 9, wherein the annealing of the nano-structured material is performed at a temperature in the range of 100 to 1200°C.

11. The method of claim 10, wherein the annealing the nano-structured material is performed for a time in the range of 1 minute to 24 hours.

12. The method of one of claims 1 to 11, wherein the nano-structured material has a nano-wire shape, a nano-rod shape, or a nano-wall shape..

13. The method of one of claims 1 to 12, wherein the substrate is formed of one selected from the group consisting of Al₂O₃, quartz, Si, GaN, and glass.
